(19) Europäisches Patentamt / European Patent Office / Office européen des brevets

(11) **EP 1 525 663 B1**

(12) **FASCICULE DE BREVET EUROPEEN**

(45) Date de publication et mention de la délivrance du brevet:
**25.04.2012 Bulletin 2012/17**

(21) Numéro de dépôt: **03755609.9**

(22) Date de dépôt: **16.07.2003**

(51) Int Cl.:
*H03M 7/30* *(2006.01)*    *H04N 7/50* *(2006.01)*

(86) Numéro de dépôt international:
**PCT/FR2003/002245**

(87) Numéro de publication internationale:
**WO 2004/012339 (05.02.2004 Gazette 2004/06)**

(54) **COMPRESSION DE DONNEES NUMERIQUES ROBUSTE AU BRUIT DE TRANSMISSION**

KOMPRESSION GEGEN LÄRMÜBERTRAGUNG ROBUSTER DIGITALER DATEN

DIGITAL DATA COMPRESSION ROBUST RELATIVE TO TRANSMISSION NOISE

(84) Etats contractants désignés:
**AT BE BG CH CY CZ DE DK EE ES FI FR GB GR HU IE IT LI LU MC NL PT RO SE SI SK TR**

(30) Priorité: **22.07.2002 FR 0209287**
**28.11.2002 FR 0214964**

(43) Date de publication de la demande:
**27.04.2005 Bulletin 2005/17**

(73) Titulaire: **Thomson Licensing**
**92130 Issy-les-Moulineaux (FR)**

(72) Inventeurs:
• **JEGOU, Hervé**
**F-29820 Bohars (FR)**
• **GUILLEMOT, Christine**
**F-35135 Chantepie (FR)**

(74) Mandataire: **Ruellan-Lemonnier, Brigitte et al**
**Technicolor**
**1-5 rue Jeanne d'Arc**
**92130 Issy-les-Moulineaux (FR)**

(56) Documents cités:
EP-A- 1 067 694    US-A- 5 298 896
US-A- 5 884 269    US-A- 6 020 923

EP 1 525 663 B1

**EP 1 525 663 B1**

**Description**

L'invention concerne la compression de données numériques, notamment pour des signaux multimédia (audio, image, vidéo, parole), et la transmission robuste de ces données sur des réseaux bruités, tels que des réseaux sans fils, des communications mobiles.

Selon le document US 6020923 il est connu de coder une séquence d'images haute résolution à partir de données dérivées d'une séquence d'images basse résolution.

Pour réduire le débit de transmission des données numériques, on les comprime, en cherchant à s'approcher du maximum théorique que les spécialistes appellent "l'entropie du signal". Pour cela, on utilise souvent des codes statistiques aussi appelés codes à longueurs variables, par exemple les codes de Huffman. Ces codes ont néanmoins l'inconvénient d'être très sensible aux erreurs de transmission. L'inversion d'un bit peut conduire à une désynchronisation du décodeur, qui a pour conséquence un décodage erroné de toutes les données qui suivent la position du bit erroné.

Les solutions actuelles de compression, transmission et décompression de signaux multimédia sur réseau, sur lesquelles on reviendra, se fondent sur l'hypothèse qu'une certaine qualité de service du transport des données est garantie. En d'autres termes, elles supposent que les couches de transport et de liaison, en s'appuyant sur l'utilisation de codes correcteurs, vont permettre d'atteindre un taux d'erreur résiduel quasi nul (c'est-à-dire vu par l'application de compression et de décompression). Mais cette hypothèse de taux d'erreur résiduel quasi nul n'est plus vraie lorsque les caractéristiques des canaux varient dans le temps (canaux non stationnaire), notamment dans les réseaux sans fil et mobiles, et pour une complexité du code de canal réaliste. En outre, l'ajout de redondance par codes correcteurs d'erreurs conduit à réduire le débit utile.

Le besoin se fait donc sentir de solutions qui soient robustes au bruit de transmission, c'est à dire qui soient peu affectées par les erreurs de bits induites par ce bruit d'une part et qui permettent une utilisation optimale de la bande passante (c'est à dire de la capacité) du réseau d'autre part.

La présente invention vient proposer des avancées en ce sens.

Selon un aspect de l'invention, il est proposé un codeur de compression de données numériques comme défini par la revendication 1.

De manière générale:

- le second flux de données est préalablement encodé.
- le reste du second flux de données est concaténé aux données transmises.

L'invention vise également un décodeur, propre à effectuer les opérations inverses ou réciproques de celle du codeur, dans ses différents aspects.

L'invention vise encore un procédé de compression de données numériques comme défini par la revendication 4.

Enfin, l'invention vise également le procédé de décompression de données numériques, comprenant les étapes réciproques de celles du procédé de compression.

D'autres caractéristiques et avantages de l'invention apparaîtront à l'examen de la description détaillée ci-après, et des dessins annexés, sur lesquels :

- la figure 1 illustre de façon schématique un procédé de création de codes,
- la figure 2 est un diagramme formant vue générale du processus d'encodage dans sa variante principale,
- la figure 2A illustre un exemple simplifié de code multiplexé, à quatre éléments,
- la figure 3 illustre un premier mode de réalisation d'un processus détaillé d'encodage,
- la figure 4 illustre une variante de réalisation du processus de la figure 3,
- la figure 5 illustre un exemple de création d'une capacité de stockage par l'attribution de plusieurs mots de code à un symbole, un flux de données q pouvant être conjointement stocké, et
- la figure 6 ou table C illustre des transformations utilisées dans un exemple où le paramètre $f_v$ est égal à 5,
- la figure 7 illustre un autre exemple simplifié de code multiplexé à quatre éléments,
- la figure 8 illustre un processus d'encodage général des figures 3 et 4,
- la figure 9 illustre un deuxième mode de réalisation d'un processus détaillé d'encodage,
- la figure 10 illustre une table de résultat d'une première variante du deuxième mode de réalisation du processus d'encodage selon la figure 9,
- la figure 11 illustre un diagramme formant vue générale d'une deuxième variante du deuxième mode de réalisation du processus d'encodage selon la figure 9
- la figure 12 un diagramme formant vue générale d'une troisième variante du deuxième mode de réalisation du processus d'encodage selon la figure 9,

En outre:

- l'annexe 1 contient des expressions utilisées dans la présente description, et
- l'annexe 2 contient des algorithmes en langage naturel utilisés dans la présente description.

Les dessins et les annexes à la description comprennent, pour l'essentiel, des éléments de caractère certain. Ils pourront donc non seulement servir à mieux faire comprendre la description, mais aussi contribuer à la définition de l'invention, le cas échéant.

De manière générale, un système de compression de signaux multimédia (image, vidéo, audio, parole) fait appel à des codes statistiques aussi appelés codes à longueurs variables. Ceux-ci permettent d'obtenir des débits approchant ce que les spécialistes appellent "l'entropie du signal". Les codes les plus utilisés dans les systèmes existants (en particulier dans les standards) sont les codes de Huffman qui ont été décrits dans l'ouvrage suivant : D.A. Huffman : "A method for the construction of minimum redundancy codes", Proc. IRE, 40 (1951), p.1098-1101.

Plus récemment, on a vu un regain d'intérêt pour les codes arithmétiques en raison de leurs performances accrues en terme de compression. Ils permettent en effet de découpler le processus d'encodage du modèle supposé de la source. Ceci permet aisément d'utiliser des modèles statistiques d'ordre supérieur. Ces codes arithmétiques ont été décrits dans des ouvrages tels que

- J.J. Rissanen "Generalized kraft inequality and arithmetic", IBM J.Res. Develop., 20:198-203, Mai 1976
- J.J. Rissanen, "Arithmetic Coding as number representations", Acta Polytech. Scand. Math., 31:44-51, Décembre 1979

ainsi que dans des brevets américains US 4 286 256, US 4 467 317, US 4 652 856.

Jusque récemment, la conception des systèmes de compression se faisait en supposant une qualité de service transport garantie. On supposait en effet que les couches inférieures du modèle OSI incorporent des codes correcteurs d'erreurs garantissant un taux d'erreur résiduel vu de l'application quasi-nul.

Les codes à longueurs variables pouvaient donc être largement utilisés malgré leur forte sensibilité au bruit de transmission. Toute erreur dans le train binaire peut engendrer une désynchronisation du décodeur et donc une propagation des erreurs sur la suite des informations décodées.

Pour pallier ce problème de propagation, les standards de premières générations (H.261, H.263, MPEG-1, MPEG-2) ont incorporé dans la syntaxe du train binaire transmis des marqueurs de synchronisation. Ce sont des mots de code longs (16 ou 22 bits constitués d'une suite de 15 ou 21 bits à '1' suivis d'un '0') non émulables par des erreurs se produisant sur les autres mots de code et qui peuvent donc être reconnus par le décodeur avec une probabilité proche de '1'.

Cela conduit à structurer le train binaire en paquets délimités par ces marqueurs de synchronisation. Cela permet de confiner la propagation des erreurs au sein du paquet. Cependant si une erreur intervient en début de paquet la suite du paquet peut être perdue. En outre, la périodicité de ces marqueurs de synchronisation doit être restreinte pour éviter une perte trop grande en efficacité de compression.

Cette hypothèse de taux d'erreur résiduel quasi nul n'est plus vraie dans les réseaux sans fil et mobiles, dont les caractéristiques des canaux varient dans le temps (canaux non stationnaires). Ce taux d'erreur résiduel vu par le décodeur des signaux de source est souvent loin d'être négligeable.

Les nouveaux standards (H.263+ et MPEG-4) ont alors fait appel à des codes à longueurs variables réversibles (RVLC). La particularité de ces codes est qu'ils peuvent être décodés du premier vers le dernier bit d'un paquet, et, à l'inverse, du dernier vers le premier bit du paquet.

Si une erreur s'est produite en milieu de paquet, cette symétrie du code permet de confiner la propagation des erreurs sur un segment en milieu de paquet au lieu de la propager jusqu'à la fin du paquet délimité par un marqueur de synchronisation. Cependant, la symétrie du code engendre une perte en efficacité de compression par rapport à un code de Huffman de l'ordre de 10 %. En outre les codes à longueurs variables réversibles n'évitent pas complètement le problème de propagation des erreurs : si une erreur se produit en début et en fin de paquet, tout le paquet risque d'être erroné.

La conception de codes qui soient à la fois performants en compression (i.e., qui permettent d'approcher l'entropie de la source), tout en étant robustes au bruit de transmission, constitue donc un enjeu important, notamment pour les futurs systèmes de communication multimédia (image, vidéo, audio, parole) mobiles. Pour ces systèmes de nouveaux standards sont à l'étude à la fois au sein de l'ITU (International Télécommunication Union) et de l'ISO (International Standard Organization).

Bien que les standards occupent une place prépondérante dans le secteur des télécommunications, une telle famille de codes peut aussi trouver des applications sur des marchés de niche faisant appel à des solutions propriétaires.

De façon générale, les procédés de compression de données numériques proposés ci-après sont mis en oeuvre par un codeur de compression de données numériques selon l'invention comprenant une module de codage et un module de traitement.

Plus spécifiquement, le module de codage établit une correspondance entre des symboles d'un premier flux de données et des mots de code, où, pour certains symboles, il existe plusieurs mots, dits redondants, correspondant au même symbole. De manière générale, un module de codage peut être toute forme de stockage présentant la correspondance définie ci-dessus, toute forme de représentation de cette correspondance ou toute fonction de codage calculant cette correspondance. Ainsi, à titre d'exemple seulement, le module de codage peut être une table de codage, un arbre de codage ou un codeur arithmétique suivant les procédés de compressions détaillés ci-après.

Le module de traitement met en oeuvre les étapes des procédés de compression de données à partir du premier flux de données et d'un second flux de données et du module de codage. Le module de traitement comprend des fonctions propre à réaliser certaines étapes des procédés et peut comprendre une transformation d'un flux binaire en un flux de variable multi-valuée. Ces fonctions comprennent une fonction de calcul ou de lecture d'une capacité de multiplexage liée au premier flux de données, une fonction d'extraction d'une partie du second flux de données. Ces fonctions seront plus particulièrement développées dans la suite de la description. De façon symétrique, les procédés de décompression de données sont mis en oeuvre par un décodeur selon l'invention.

De façon générale, le procédé décrit ci-après consiste à créer des codes de longueur fixée pour les données de source importantes (flux $s_H$), en attribuant plusieurs mots de codes à chaque réalisation possible de cette source.

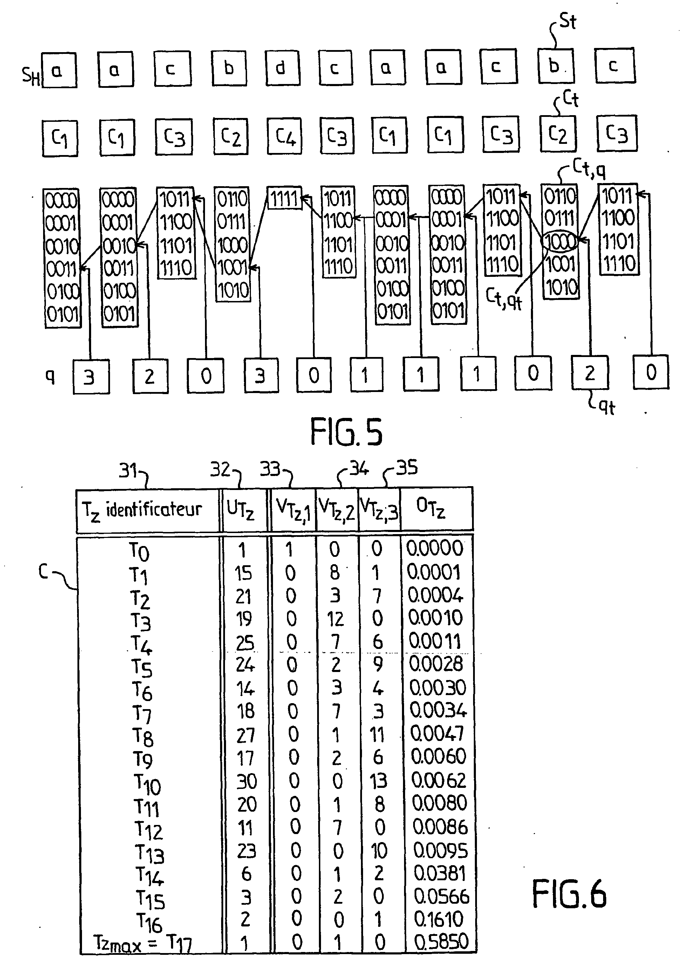

Ainsi, pour transmettre un symbole, il est possible de choisir parmi les différentes représentations possibles de celui-ci. Ce choix, qui est une variable multi-valuée, définit une capacité de stockage qui va pouvoir être utilisée pour transmettre conjointement d'autres données (cf. exemple de la figure 5 détaillée ci-après). Ce sont les données d'importance moindre, représentées par un flux noté $s_L$, qui vont être représentées via la représentation multiple des symboles.

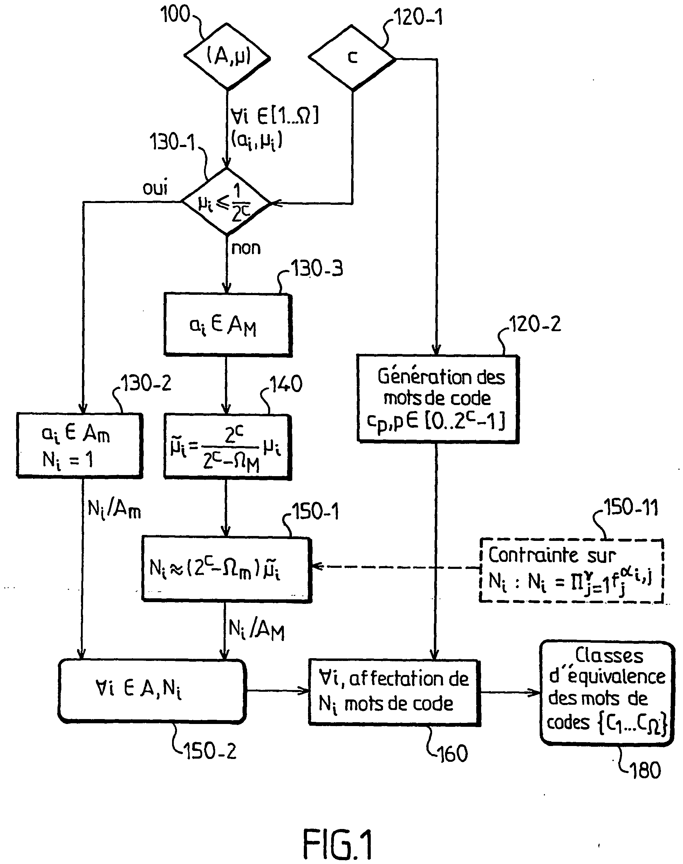

La figure 1 présente le procédé de création de ces codes, plus précisément le procédé de création de codes multiplexés.

A l'étape 100, la source importante, $s_H$, prend ses valeurs dans un alphabet à $\Omega$ éléments, qui peut être défini par l'expression (E1) en annexe. La loi $\mu$ de probabilité d'apparition des symboles sur cet alphabet est supposée connue. On note $\mu_i$ la probabilité associée au symbole $a_i$ de l'alphabet de la source $s_H$, comme représenté par l'expression (E2).

Le procédé de création des codes, représenté sur la figure 1, peut ensuite se décomposer en 2 étapes principales:

- Pour chaque symbole $a_i$, choix du nombre $N_i$ de mots de code affectés à ce symbole,
- Allocation des mots de codes aux symboles.

La première étape consiste en une sélection des paramètres de codes c et $(N_i)$ décomposée en différentes étapes 120, 130, 140 et 150.

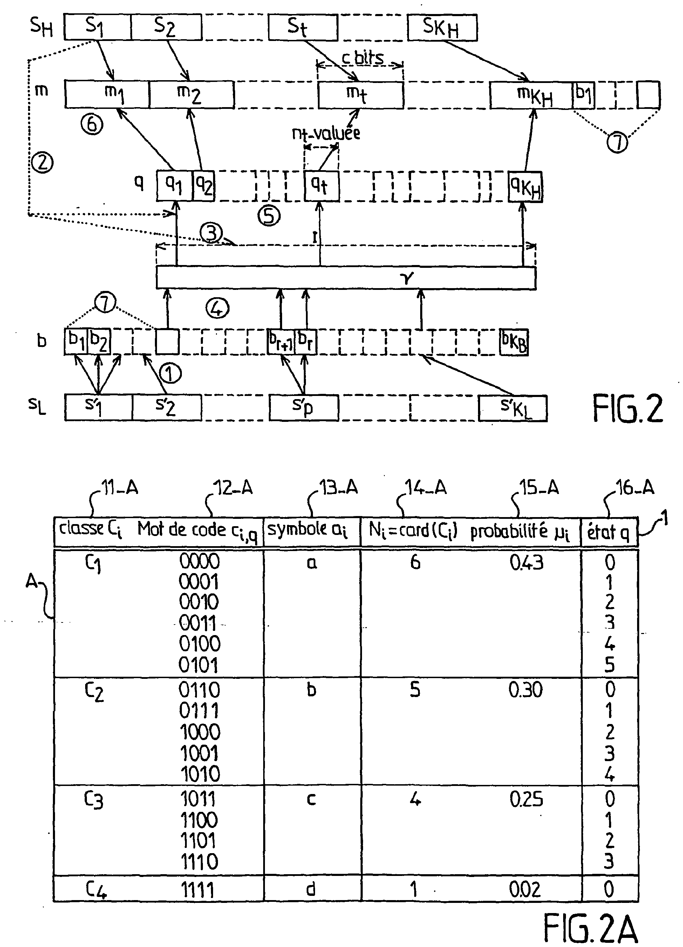

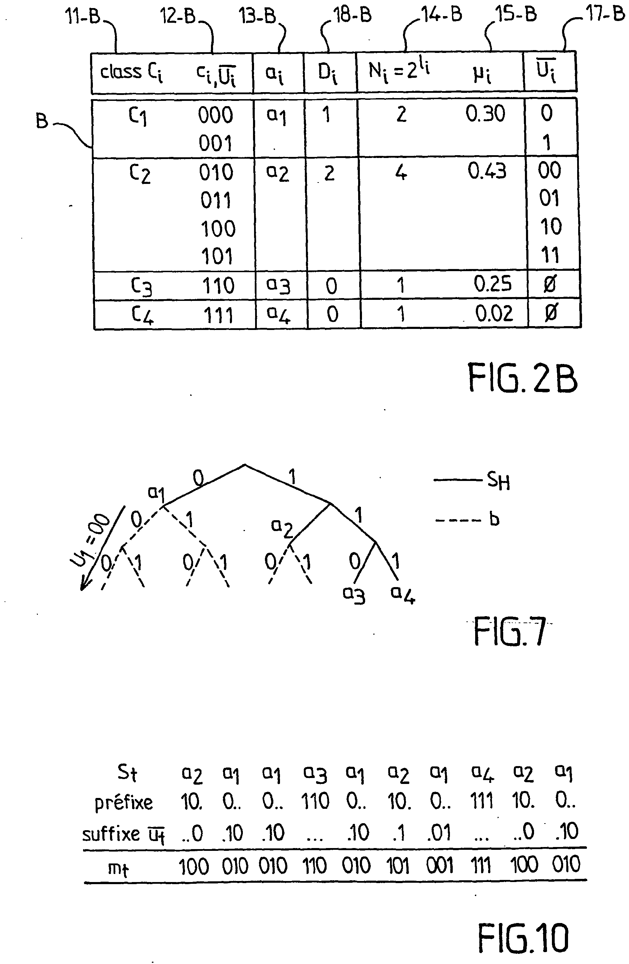

A l'étape 120-1, un paramètre c de longueur de mot de code, en nombre de bits, est choisi. Dans une première réalisation (en référence aux figures 2A et 5), le paramètre c prend la valeur c = 4. Dans une autre réalisation (en référence aux figures 2B, 7 et 10), le paramètre c prend la valeur 3. Ceci définit $2^c$ mots de codes à l'étape 120-2, à répartir entre les symboles de l'alphabet A.

En fonction des valeurs possibles de la probabilité $\mu_i$ à l'étape 130-1, on partitionne l'ensemble des symboles de l'alphabet A en deux sous-ensembles $A_m$ et $A_M$ respectivement à l'étape 130-2 et à l'étape 130-3. Le premier est l'ensemble des symboles $a_i$ dont la probabilité $\mu_i$ est inférieure ou égale à $1/2^c$, le second est son complémentaire dans A. Les cardinaux de ces ensembles sont notés respectivement $\Omega_m$ et $\Omega_M$.

A l'étape 140, la loi de probabilité $\tilde{\mu}$ sur les symboles de $A_M$ est alors calculée. Elle est donnée par l'expression (E3).

A l'étape 150-1, le nombre de mots de codes par symbole est alors choisi de manière à vérifier approximativement l'expression (E4), sous la contrainte de l'expression (E5) pour le sous-ensemble $A_M$. Dans ce but, un algorithme classique d'optimisation peut être utilisé. A l'étape 150-2, le nombre de mots de codes par symbole est déterminé pour l'ensemble des symboles de l'alphabet A.

Dans une variante du procédé de création des codes, comprenant les étapes 120, 130, 140 et 150, une étape additionnelle est ajoutée après l'étape 150, et les étapes 120-1 et 150-1 se déclinent respectivement sous la forme suivante.

Soient $f_1 = 2$, $f_2 = 3$, $f_3 = 5$ ..., $f_v$, les v premiers nombres premiers. En plus du paramètre c à l'étape 120-1, un nombre premier $f_v$ est également choisi parmi ces nombres premiers.

A l'étape 150-1, on procède de la même manière, mais en ajoutant une contrainte supplémentaire de l'étape 150-11 pour le choix du nombre de mots de code $N_i$ associés à chaque symbole : la décomposition en facteurs premiers de tous les $N_i$ ne doit pas contenir de facteur premier supérieur à $f_v$.

Après l'étape 150-1, la décomposition en facteurs premiers de chaque $N_i$ est alors effectuée, et on calcule

pour tout $N_i$ le nombre de fois que chaque facteur premier $f_i$, avec $1 \le j \le v$, apparaît dans cette décomposition. Ce nombre est noté $\alpha_{i,j}$, où i indexe le symbole $\alpha_i$ considéré et j indexe le nombre premier $f_j$ considéré. La correspondance entre $a_i$ et les nombres $\alpha_{i,1}...\alpha_{i,v}$ peut être stockée dans une table dite "table alpha".

L'étape additionnelle consiste en une allocation des mots de codes aux symboles. Cette étape se décompose en différentes étapes 160 et 180 développées ci-après.

A l'étape 160, un étiquetage binaire (0000, 0001, ...) des symboles rangés selon, à titre d'exemple uniquement, un ordre lexicographique est réalisé. Ceci permet d'affecter aux différents symboles $N_i$ de mots de codes, le paramètre $N_i$ étant un entier déterminé à l'étape précédente (150-2). L'ensemble des mots de codes ainsi associés à un symbole $a_i$ est appelé classe d'équivalence de $a_i$, et notée $C_i$ à l'étape 180.

On associe alors aux mots de codes de chaque classe d'équivalence une valeur entre 0 et $N_i$ -1, appelée ici état. Cette valeur identifie le mot de code au sein de la classe d'équivalence.

Ainsi, à chaque mot de code $c_i$ est associé un symbole $a_i$ et une variable d'état comprise entre 0 et $N_i - 1$, comme illustré par l'expression (E6).

Un exemple de code ainsi construit est donné dans la table A, figure 2A pour $f_v = 5$ et c= 4. La table A comprend pour chaque symbole $a_i$ de la colonne 13-A, une colonne 11-A comprenant les classes $C_i$, une colonne 12-A comprenant les mots de code associés à chaque classe, une colonne 14-A comprenant les nombres $N_i$ de mots de code par classe, une colonne 15-A comprenant les probabilités $\mu_i$ associé à chaque classe, une colonne 16-A comprenant un état q de chaque mot de code d'une classe. Dans cet exemple, les symboles $a_i$ comprennent 4 éléments de l'alphabet.

Une variante de code construit est donnée dans la table B, figure 2B pour $f_v = 2$ et c = 3. Cette table B définit un code multiplexé binaire, c'est-à-dire un code multiplexé tel que pour tout symbole $a_i$, le cardinal $N_i$ de la classe d'équivalence associé est une puissance entière de 2. En notant $l_i$ cette puissance, le cardinal $N_i$ de la classe d'équivalence vérifie E(11). La table B comprend pour chaque symbole $a_i$ de la colonne 13-B, une colonne 11-B comprenant les classes $C_i$, une colonne 12-B comprenant les mots de code associés à chaque classe, une colonne 14-B comprenant les nombres $N_i$ de mots de code par classe. Dans cet exemple, la variable d'état q n'existe pas mais d'autres indications sont précisées et leur utilité sera plus largement comprise à la lecture de la description : une colonne 15-B comprend les probabilités $\mu_i$ associées chacune à une classe, une colonne 18-B comprend un nombre Di de bits pouvant être stockés, Di étant associé à chaque classe, une colonne 17-B comprend un jeu $\overline{U}_i$ de Di bits pour chaque mot de code d'une classe. Dans cet exemple, les symboles $a_i$ comprennent 4 éléments de l'alphabet avec i prenant les valeurs de 1 à 4.

La condition (E11) sur les cardinaux des classes d'équivalence mène au fait que le choix d'un mot de code au sein d'une classe d'équivalence permet de stocker un nombre de bit entier égal au logarithme en base 2 du cardinal de la classe d'équivalence. Ce nombre de bits Di peut donc s'écrire selon (E12). Di représente une capacité de multiplexage d'un symbole donné. Les tables A et B sont des tables de codage, appelées aussi tables de mots de code multiplexés ou table de code multiplexé.

Selon une troisième variante de réalisation, un code multiplexé binaire peut également être construit à partir d'un arbre binaire de codage associé à un préfixe de mot de code, ce préfixe étant de longueur variable et inférieure à une longueur maximale étant la hauteur de l'arbre, tel que le code de Huffman présenté sur la figure 7. La relation "inférieure" est à prendre dans le sens "inférieur ou égal". L'arbre se divise d'abord en deux branches prenant respectivement la valeur 1 et la valeur 0. De manière récurrente, chaque branche de l'arbre est divisée en deux branches prenant respectivement la valeur 0 et la valeur 1. Le paramètre c est donné par la hauteur de l'arbre, c'est-à-dire par la longueur du préfixe le plus long (dans l'exemple c = 3) de l'arbre. Une classe d'équivalence $C_i$ est définie par un ensemble de mots de code de longueur fixe ayant chacun une première partie en commun, appelée préfixe commun. Ce préfixe commun est la partie du mot de code à longueur variable utilisée pour représenter le symbole $a_i$ et symbolisée sur la figure 7 par le trajet formé par les branches successives en trait plein. Pour certains trajets en trait plein représentant un symbole $a_i$, il reste un certain nombre de trajet en trait tireté représentant chacun une deuxième partie du mot de code appelée suffixe. Le suffixe d'un mot de code définit le jeu de bit Ui comme indiqué sur la figure par une flèche.

Ainsi, l'arbre de codage est défini comme un module de codage, mettant en correspondance les symboles du flux de données prioritaire et des mots de code, où, pour certains symboles, il existe plusieurs mots, dits redondants, correspondant au même symbole. Ces mots de code sont de longueur fixe et comprennent une première et une deuxième partie de mot de code, par exemple un préfixe et un suffixe de longueurs variables. Dans une variante, la première et la deuxième partie de mot de code peuvent correspondre respectivement au suffixe et au préfixe du mot de code, De manière plus générale, un mot de code peut comprendre plusieurs parties de code.

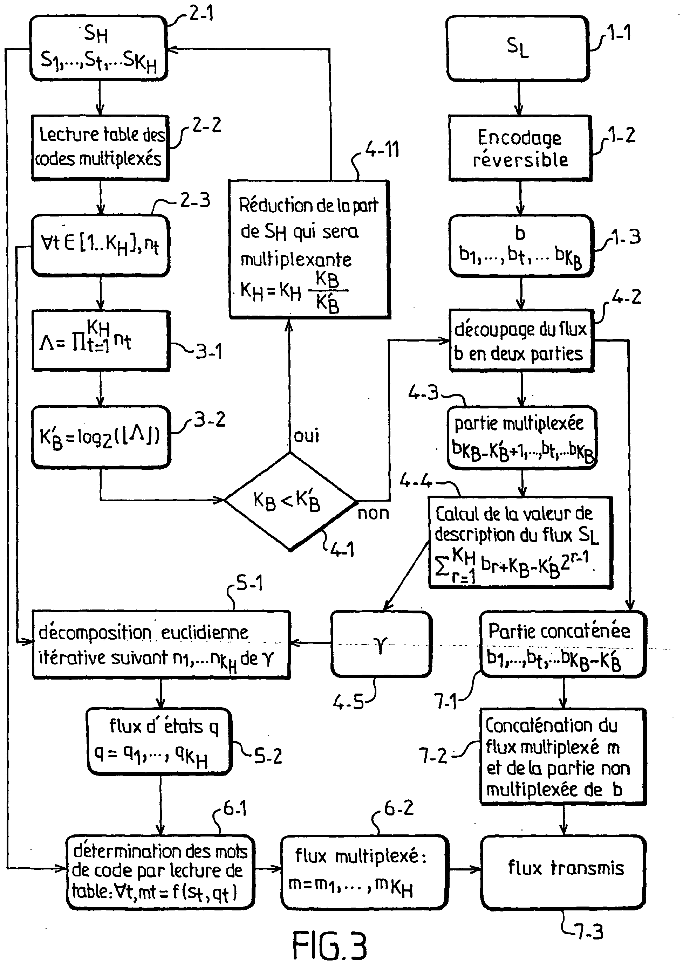

Les figures 2 et 3 illustrent le procédé de codage, appelé également d'encodage.

Le processus d'encodage se décompose de la manière suivante:

- étapes 1: le flux de données d'importance moindre $S_L$ de l'étape 1-1 est encodé en une suite binaire b = ($b_1$, $b_2$, ..., $b_{KB}$) en utilisant un encodage réversible à l'étape 1-2. A cet effet, un codeur réversible de type Huffman ou codeur arithmétique (non restrictif) peut être utilisé. Cela aboutit à la génération d'une suite de bits, notée b à l'étape 1-3.

- étapes 2 : de la séquence de symboles $s_1$, $s_2$, ..., $s_{KH}$ du flux $s_H$ à l'étape 2-1 et de la lecture de table des mots de code multiplexés à l'étape 2-2, on déduit les valeurs $n_1$, $n_2$ ,... , $n_{KH}$ associées à l'étape 2-3. Par exemple, pour un symbole $s_1$ correspondant au symbole $a_i$ d'une table de mots de codes multiplexés, $n_1$ prend la valeur de $N_i$ correspondant à la réalisation du symbole $a_i$.

- étapes 3: on en déduit la valeur A, ici selon l'expression (E7) à l'étape 3-1. On calcule le nombre $\mathbf{K'_B}$ de bits qui vont pouvoir être stockés en utilisant la redondance intrinsèque des codes multiplexés, selon l'expression (E8) à l'étape 3-2. Ce nombre $K'_B$ de bits représente la capacité de multiplexage du flux $\mathbf{s_H}$ pour ce processus d'encodage.

- étapes 4: à condition que $K_B < K_B$, à l'étape 4-1, $K'_B$ bits du flux b, par exemple les $K'_B$ derniers bits du flux b (étapes 4-2, 4-3) sont utilisés pour calculer (étape 4-4) un entier long $\gamma$ (étape 4-5), donné ici par la relation (E9). Ceci correspond à la transformation des $K'_B$ derniers bits du flux binaire en une variable globale. Si la condition $K_B < K_B$, n'est pas vérifiée à l'étape 4-1, le procédé reprend à l'étape 2-1 en réduisant la valeur $K_H$ (étape 4-11).

- étapes 5 : la valeur $\gamma$ permet alors de calculer les états $q_t$, $1 \le t \le K_H$ (étape 5-2), en utilisant par exemple une méthode de décomposition euclidienne généralisée (étape 5-1), comme illustré dans l'algorithme (A1) annexé. Il s'agit d'une génération de flux d'états $q_t$, $q_t$ étant une variable multivaluée.

- étapes 6 : pour tout t tel que $1 \le t \le K_H$, la connaissance du symbole $s_t$ et de l'état $q_t$ calculé à l'étape précédente permet de choisir le mot de code dans la table des mots de codes multiplexés (étape 6-1). On obtient le flux multiplexé m comprenant les mots de code $m_1$ à $m_{KH}$ (étape 6-2).

- étapes 7 : les $K_B$ - $K'_B$ bits du flux d'importance moindre (étape 7-1) sont alors concaténés à la séquence de mots de codes multiplexés précédemment construite (étape 7-2) pour former le flux transmis (étape 7-3).

Au moins l'étape 3 est mise en oeuvre par la fonction de calcul du module de traitement. Les étapes 4, 5 et 6 au moins sont mises en oeuvre par la fonction d'extraction du module de traitement.

De façon générale, pour un procédé d'encodage, un processus de décodage associé est effectué en procédant aux opérations inverses de celles de l'encodage.

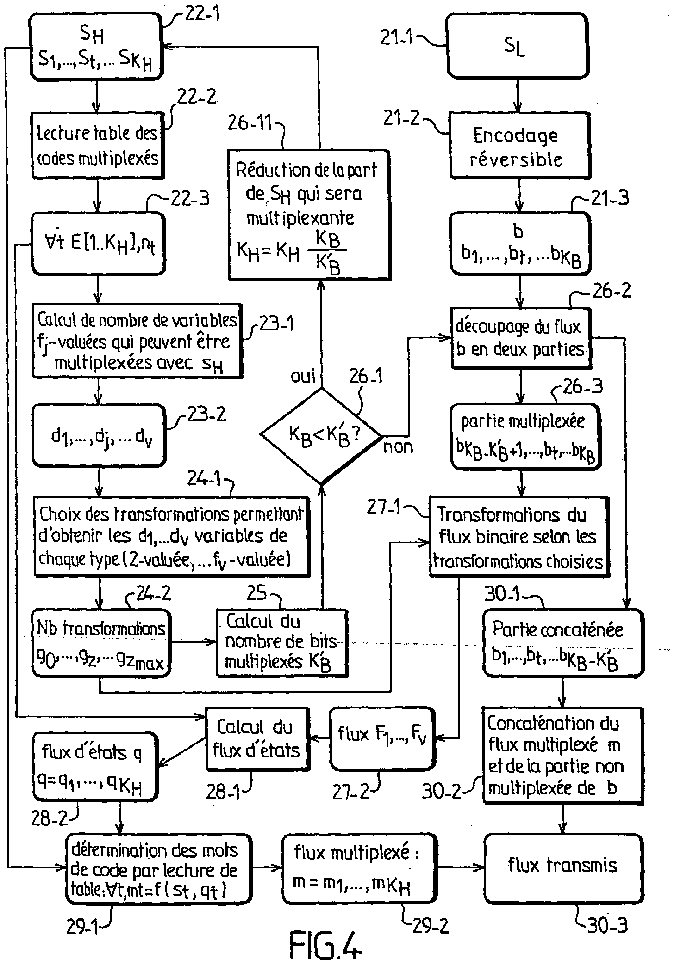

Une variante du procédé d'encodage est illustrée sur la figure 4 et permet d'éviter les calculs sur entiers longs. La variante du processus d'encodage se décompose de la manière suivante:

- étapes 21 : elles correspondent aux étapes 1 de la figure 3.

- étapes 22 : elles correspondent aux étapes 2 de la figure 3.

- étapes 23: le nombre total de fois où chaque facteur premier $f_j$ apparaît dans l'ensemble des décompositions en facteurs de la séquence de variables $n_t$ est alors déterminée à partir de la table dite "alpha" (étapes 23-1 et 23-2). Il est noté $d_j$ dans la suite, et représente le nombre de variables $f_j$-valuées qui peuvent être multiplexées avec le flux $\mathbf{s_H}$. Ainsi, pour chaque facteur premier $f_j$, $d_j$ représente la somme des $\alpha_{t,j}$ de la séquence de variables $n_t$.

- étapes 24 : on choisit alors les transformations qui vont être utilisées pour transformer le train binaire en ces variables $f_j$-valuées (étape 24-1). Ces transformations dépendent de la valeur de $f_v$ choisie. Les transformations utilisées pour $f_v = 5$ sont présentées dans la table C de la figure 5.

Elles se présentent sous la forme illustrée dans les expressions (E10) annexées.

Ainsi, chaque transformation Tz prend $u_{Tz}$ bits en entrée (que l'on notera par la suite $u_T$ par simplification pour un z donné) et les transforment en respectivement $v_{T,1}$, $v_{T,2}$ ,..., $V_{T,v}$ variables 2, 3, 5,. . . , $f_v$ -valuées. Dans l'exemple de la table C pour $f_v = 5$, chaque transformation Tz de la colonne 31 prend $u_T$ bits de la colonne 32 en entrée et les transforment en respectivement $v_{T,1}$, $v_{T,2}$, $v_{T,3}$ variables 2, 3, 5 -valuées des colonnes 33, 34, 35. Or le nombre requis de variables de chaque type est connu: pour chaque type de variable $f_j$, il est $d_j$ (cf. étape 23-2).

L'algorithme A2 annexé peut être utilisé pour calculer le nombre $g_{Tz}$ de fois que la transformation T z doit être utilisée (étape 24-2), et ceci pour une variable z allant de 0 à $z_{max}$.(Les transformations sont supposées être classées dans l'ordre décroissant de leur pertinence dans la table ).

- étape 25 : $K_{B'}$, le nombre de bits multiplexés, est calculé en effectuant le produit du nombre de fois $g_{Tz}$ qu'une transformation Tz doit être utilisée avec le nombre de bits $u_T$ en entrée de la transformation et en additionnant ces produits pour toutes les transformations z utilisées. Ce nombre $K'_B$ de bits représente la capacité de multiplexage du flux $s_H$ pour ce processus d'encodage. Cette étape 25 correspond aux étapes 3 de la figure 3. Les étapes suivantes 26-1, 26-2, 26-3, et 26-11 correspondent aux étapes 4-1, 4-2, 4-3 et 4-11 de la figure 3.

- étapes 27 : ayant choisi le nombre de transformations de chaque type qui seront utilisées, on les applique à la fin du flux binaire b (étape 27-1).

Pour chaque transformation Tz, les $u_T$ bits en entrée sont vus comme la représentation binaire d'un entier e.

Cet entier est alors décomposé en plusieurs variables $f_j$ -valuées, comme précisé dans les expressions (E10). On note $e_{r,j}$ ces variables, où :

j indique que la valeur obtenue est la réalisation d'une variable $f_j$-valuée, et
r indique le numéro de variable $f_j$ -valuée.

Les valeurs des $e_{r,j}$ peuvent s'obtenir à partir de e avec le procédé de l'algorithme A3. Cet algorithme est réitéré un nombre $g_{Tz}$ de fois pour chaque transformation Tz.

A l'issue de cette étape 27-1, les résultats obtenus se présentent sous la forme des expressions (E10) et sont concaténés de manière à obtenir $\nu$ séquences de variables disponibles (étape 27-2):

- la première, noté $F_1$, est une séquence de longueur $d_1$ de variables 2-valuée (bits),
- la j-ème, noté $F_j$, est une séquence de longueur $d_j$ de variables $f_j$-valuée. Des pointeurs de positions, appelés $t_j$, sont associés aux séquences, ils sont initialement positionnés sur le début de chaque séquence.

- étapes 28 : à partir de ces variables, on calcule le flux d'état (étape 28-1) dont le résultat est (étape 28-2) :

$$q = (q_1, q_2 ,..., q_{KH}).$$

Pour effectuer ce calcul, on peut procéder de la manière suivante :

- pour tout t tel que $1 \leq t \leq K_H$, et ainsi pour chaque symbole $s_t$, la décomposition en facteurs premiers de $n_t$ permet de déterminer le nombre $\alpha_{t,j}$ de variables de chaque type (2-valuées,..., $f_j$-valuées,...,$f_\nu$-valuées, j variant de 1 à v). Chaque séquence $F_j$ précédemment obtenue est divisée en $K_H$ segments successifs comprenant $\alpha_{t,j}$ bits pour t variant de 1 à $K_H$. Le procédé est réitéré pour j variant de 1 à $\nu$. Chaque variable $n_t$- valuée ($q_t$) est obtenue par le procédé réciproque de la décomposition euclidienne itérative, appliquée aux segments $F_{t,j}$ de variables $f_j$- valuées. Un exemple de l'implémentation de ce procédé est décrit par l'algorithme A4. Notons qu'à la fin de ces étapes 28, toutes les variables des flux $F_j$ ont été utilisées.

- étapes 29 : pour tout t tel que $1 \leq t \leq K_H$, la connaissance du symbole $s_t$ et de l'état $q_t$ calculé à l'étape précédente permet de choisir le mot de code dans la table des mots de codes multiplexés (étapes 29-1). Le flux multiplexé m est alors obtenu (étape 29-2).

- étapes 30 : les $K_H$ - $K'_H$ bits du flux d'importance moindre (étapes 30-1) sont alors concaténés à la séquence de mots de codes multiplexés précédemment évaluée (étape 30-2). On obtient le flux transmis (étape 30-3).

Au moins l'étape 25 est mise en oeuvre par la fonction de calcul du module de traitement. Au moins l'étape 27 est mise en oeuvre par la fonction d'extraction du module de traitement.

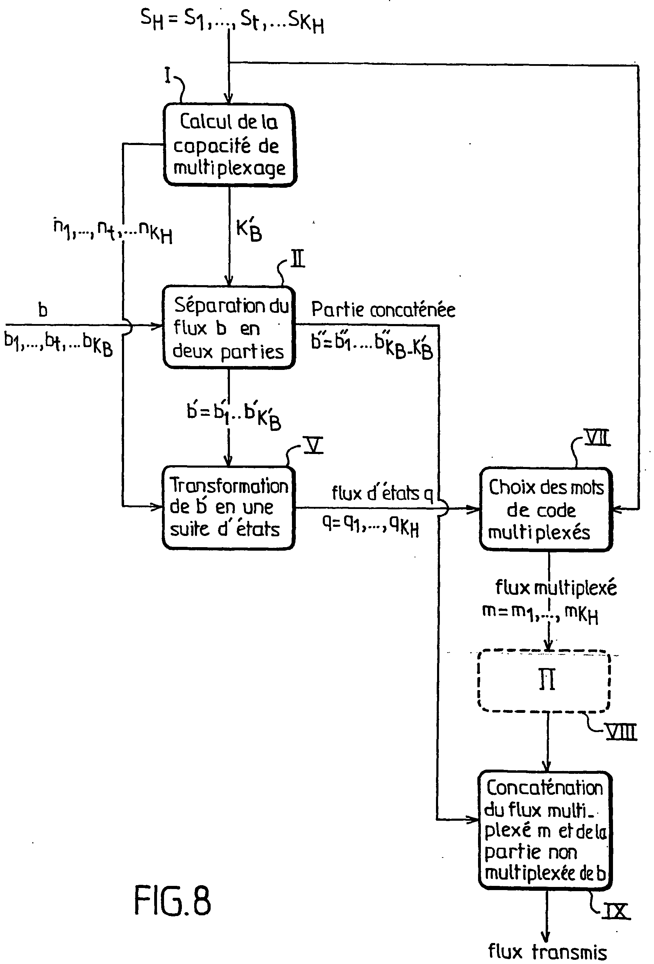

Les procédés d'encodage présentés en référence aux figures 2, 3 et 4 peuvent être généralisés selon le procédé d'encodage de la figure 8 :

- à partir de la table de mots de code multiplexés et de la séquence de symboles $s_H$, les valeurs $n_1$, $n_2$ ,... , $n_{KH}$ associées sont calculées de manière à calculer la capacité de multiplexage $K'_B$ de la séquence de symboles $s_H$ à l'étape I.
- le flux b pré-encodé est divisé en deux parties b' et b" à l'étape II en fonction de la capacité de multiplexage $K'_B$,
- la partie b' du flux est transformée en une suite d'états q en utilisant les valeurs $n_1$, $n_2$,... , $n_{KH}$ à l'étape V
- à partir de cette suite d'états q et de la table de mots de codes multiplexés, les mots de code multiplexés sont choisis à l'étape VII,
- ces mots de code sont assemblés pour former un flux multiplexé m à l'étape VIII,
- la partie concaténée b" du flux b est concaténée avec le flux multiplexé m à l'étape IX.

Au moins l'étape I est mise en oeuvre par la fonction de calcul du module de traitement. L'étape II au moins est mise en oeuvre par la fonction d'extraction du module de traitement.

Un exemple de création d'une capacité de stockage selon l'invention est illustré sur la figure 5. Ainsi, pour chaque symbole $s_t$ du flux de données $s_H$ est attribuée une classe correspondante $C_t$ et les mots de code associés $c_{t,q}$ en fonction d'une table de codage. Chaque état $q_t$ d'un flux de données q peut être conjointement stocké après le choix du mot de code $c_{t,qt}$ dans la table de mots de code multiplexés.

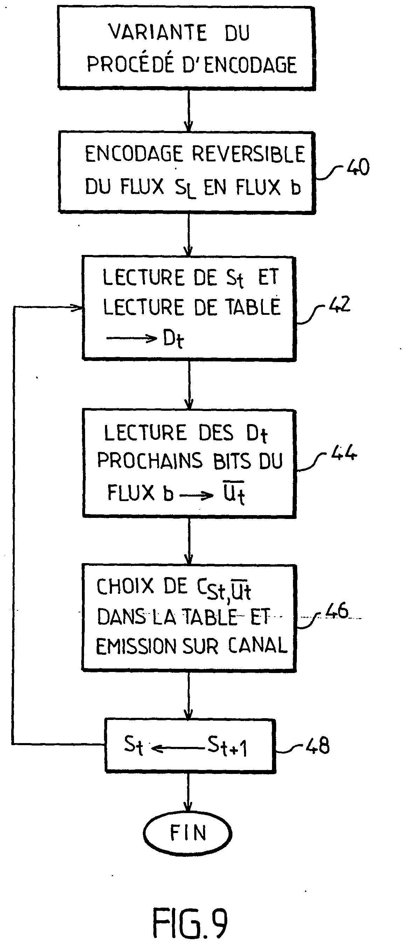

Dans le cas de la conversion du train binaire de priorité moindre, la variante du procédé d'encodage avec $f_v$ = 2 peut être utilisée. Une autre variante décrite ci-après en référence à la figure 9 peut avantageusement être utilisée. La table B de la figure 2B est utilisée dans cet exemple.

La partie du procédé de conversion du train binaire se résume donc aux étapes suivantes :

- étape 40: elle correspond aux étapes 1 de la figure 3.

- étape 42 : de la lecture du symbole $s_t$ et de la lecture de table de codes multiplexsé binaires, on déduit la valeur $D_t$ associée. Cette valeur $D_t$ correspond au nombre de bits qui peuvent être conjointement codés avec $s_t$. $D_t$ est une capacité de multiplexage d'un symbole donné.

- étape 44: les $D_t$ prochains bits du train binaire b pré-encodé sont lus. Il est noté que le train binaire est lu au fur et à mesure en fonction d'un pointeur de positionnement. Ces $D_t$ prochains bits sont notés $\overline{u_t}$ et jouent le même rôle que les états ($q_t$).

- étape 46 : le mot de code $c_{s_t,\overline{ut}}$ est choisi dans la table des codes multiplexés binaires en fonction du symbole $s_t$ et des bits $\overline{u_t}$, la table étant indexée par $a_i$ et $\overline{U_i}$. Ce mot de code est émis sur le canal,

- étape 48 : pour chaque symbole $s_t$, du flux **$s_H$,** t variant de 1 à **$K_H$** les étapes 42 à 46 sont effectuées.

Au moins l'étape 42 est mise en oeuvre par la fonction de calcul du module de traitement. L'étape 44 au moins est mise en oeuvre par la fonction d'extraction du module de traitement.

A titre d'exemple d'application du procédé de la figure 9, on considère la séquence de plus haute priorité à transmettre $s_H = a_H\, a_2\, a_2\, a_3\, a_2\, a_1\, a_2\, a_4\, a_1\, a_2$, de longueur $K_H$ = 10, et le train binaire pré-encodé de faible priorité b = 0101010101010. Le nombre de bits qui peuvent être multiplexés avec chaque réalisation de **$s_H$** est donné, pour t variant de 1 à $K_H$, par ($d_t$) = (1,2, 2, 0, 2, 1, 2, 0, 1, 2). Le nombre de bits $d_t$ du train binaire b est lu au fur et à mesure pour t variant de 1 à $K_H$ de manière à obtenir les séquences $\overline{u_t}$ de bits ($\overline{u_t}$, ..., $\overline{u_{KH}}$) = (0,10,10, $\varnothing$, 10, 1, 01, $\varnothing$, 0, 10). Alors, pour tout t, le couple ($a_t$, $\overline{u_t}$) indexe un mot de code dans la table des codes multiplexés binaires. Le train binaire effectivement transmis est 000 100 100 110 100 001 011 111 000 100.

En variante, le procédé de la figure 9 peut également utilisé l'arbre de codage. Dans cette variante, les étapes 42 à 46 se présente sous la forme suivante :

- étape 42 : de la lecture du symbole $s_t$ et de la lecture de l'arbre binaire de codage, on obtient le préfixe du mot de code pour le symbole $s_t$. Du nombre de bits de ce préfixe, on déduit le nombre de bits $D_t$ qui peuvent être conjointement codés avec $s_t$ pour former une suite de bits d'une longueur totale égale à la hauteur de l'arbre de codage. $D_t$ est une capacité de multiplexage d'un symbole donné.

- étape 44: les $D_t$ prochains bits du train binaire **b** pré-encodé sont lus. Il est noté que le train binaire est lu au fur et à mesure en fonction d'un pointeur de positionnement. Ces $D_t$ prochains bits sont notés $\overline{u_t}$.

- étape 46 : le mot de code émis sur le canal résulte de la concaténation du préfixe du mot de code pour le symbole $s_t$ et des bits $\overline{u_t}$ du train binaire b. Ainsi, l'utilisation du train binaire b permet de faire un choix parmi les mots de code possibles indiqués en trait tiretés sur l'arbre de codage de la figure 7 pour un symbole donné.

L'étape 44 au moins est mise en oeuvre par la fonction d'extraction du module de traitement.

A titre d'exemple, en utilisant la séquence **$s_H$** et le train binaire **b** indiqués précédemment dans le cas de la figure 10 et l'arbre de codage de la figure 7 pour déterminer les préfixes des mots de code, il est obtenu le flux $m_t$ de mots de code par concaténation des préfixes et des suffixes $\overline{u_t}$.

De manière générale, l'arbre de codage permet de définir un préfixe de mots de code pour chaque symbole du flux **$s_H$,** ce qui revient à définir plusieurs mots de code possibles pour certains symboles. Le choix parmi ces mots de code possibles sera fait une fois faites la lecture du code binaire pour la détermination du suffixe du mot de code et la formation du mot de code par concaténation du préfixe et du suffixe. Le calcul de la somme de l'ensemble des $D_t$

associés aux symboles formant le flux $s_H$ permet de déterminer la capacité de multiplexage du flux $s_H$.

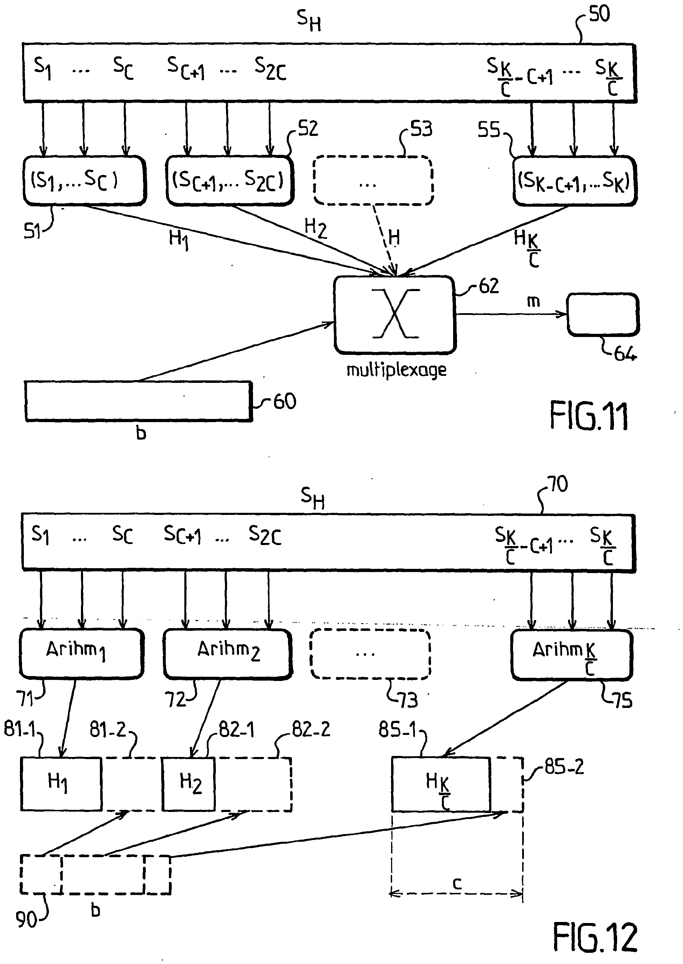

D'autres variantes du procédé d'encodage sont illustrées ci-après en référence aux figures 11 et 12.

Il peut être intéressant de considérer de créer un code multiplexé non pas sur l'alphabet, mais sur un "alphabet produit". On appelle "alphabet produit", un alphabet constitué non pas de symboles mais de séquences de symboles. Dans l'exemple de la figure 11, la source $s_H$ 50 comprend K symboles. Elle est convertie en une source de C-uplet notée H (de longueur K /C), ces C-uplets se dénommant H1, H2, H3, ...$H_{K/C}$ et respectivement numérotés 51, 52, 53 et 55. Tout C-uplet de symboles a la probabilité d'apparition (E13). Il en est déduit le calcul de la distribution de probabilité $\mu_H$ associé aux C-uplets. La création de l'arbre binaire de codage (appelé "arbre binaire de codage produit") est effectuée en considérant, pour chaque C-uplet, les probabilités d'apparition de chaque séquence de longueur C données en (E13). Le préfixe du mot de code associé à une séquence de symboles est lu sur l'arbre de codage.

D'après la figure 11, pour chaque séquence de symboles, la fonction de multiplexage 62 regroupe un certain nombre de fonctions effectuant les étapes correspondant au procédé en variante de la figure 9. Dans chaque étape, le "symbole" est remplacé par une "séquence de symboles ". Ainsi, le procédé d'encodage utilisant un arbre de codage est appliqué directement sur les réalisations de C-uplets de la source **H.**

Si la taille de l'alphabet A est trop importante pour pouvoir utiliser un arbre de codage , il est également possible de remplacer "l'arbre de codage produit" par un code arithmétique comme illustré sur la figure 12. Ainsi, la source $s_H$ 70 est découpée en C-uplets, ce qui conduit à un nombre de C-uplets égal à K/C. Ces C-uplets peuvent être relativement longs et sont encodés par des codeurs arithmétiques (non restrictif) indépendants. Dans l'exemple de la figure 12, chaque C-uplet est encodé par un codeur arithmétique distinct 71, 72, 73 et 75. La sortie des ces codeurs arithmétiques sont des suites $H_1$, $H_2$, $H_{K/C}$ de bits de longueur variables numérotés 81-1, 82-1, 85-1. La longueur c des mots de codes correspond à la plus longue suite de bits Ht possible en sortie des codeurs arithmétiques. Chaque suite de bits est alors vue comme un préfixe d'un mot de code. Pour chaque préfixe de longueur inférieure strictement à la longueur c, il existe plusieurs mots de code de longueur c correspondant au même symbole.

La formation d'un mot de code est la même que dans la variante de "l'alphabet produit". Ainsi, le flux-binaire encodé **b** numéroté 90 est lu au fur et à mesure pour former les suffixes 81-2, 82-2, 85-2 de façon à compléter les préfixes 81-1, 82-1, 85-1 et former les mots de code multiplexés. Si le nombre K/C n'est pas un entier, les C' = K -C [K/C] derniers symboles forment un C'-uplet qui est encodé arithmétiquement.

Comme indiqué pour la figure 9, du nombre de bits d'un préfixe, on déduit le nombre de bits $D_t$ (1< t< K) qui peuvent être conjointement codés avec $H_t$ pour former une suite de bits d'une longueur totale égale à la hauteur de l'arbre de codage. $D_t$ est une capacité de multiplexage d'une séquence de symboles donnée. Le calcul de la somme de l'ensemble des $D_t$ associés aux séquences de symboles formant la source H permet de déterminer la capacité de multiplexage du flux $s_H$.

De manière générale, un codeur arithmétique ou un arbre de codage permet d'établir un préfixe de mots de code pour chaque séquence de symboles, ce qui revient à définir plusieurs mots de code possibles pour certaines séquences de symboles. Le choix parmi ces mots de code possibles sera fait une fois faites la lecture du code binaire pour la détermination du suffixe du mot de code et la formation du mot de code par concaténation du préfixe et du suffixe.

Ainsi, l'invention permet le multiplexage de deux flux de données $S_H$ et $S_L$, afin de diminuer la sensibilité aux erreurs de l'un d'eux $S_H$, désigné comme plus important ou prioritaire. Ces deux flux peuvent être distingués dans la même source de signaux, notamment comme dans les quelques exemples suivants de sources $S_H$ et $S_L$ :

- basses fréquences et hautes fréquences extraites par décomposition multi-résolution (par bancs de filtres, transformées en ondelettes) d'un signal,

- information de texture (ex : coefficients DCT, coefficients ondelettes) et information de mouvement,

- bits de poids forts et bits de poids faibles des coefficients ondelettes ou des échantillons quantifiés d'un signal.

Bien entendu, l'énumération ci-dessus n'a aucun caractère exhaustif.

Par ailleurs, dans la mesure où les mots de code sont de longueur fixe (ou bien si l'on utilisait des marqueurs de synchronisation), l'invention permet la création d'un code multiplexé permettant de décrire conjointement deux flux, dont un au moins bénéficie d'une synchronisation parfaite.

Annexe 1 - Formules

$$(E1) \qquad \mathcal{A} = \{a_1, \ldots, a_i, \ldots, a_\Omega\}$$

$$(E2) \qquad \mu_i = P(a_i)$$

$$(E3) \qquad \tilde{\mu}_i = \frac{2^c}{2^c - \Omega_M} \mu_i$$

$$(E4) \qquad N_i = (2^c - \Omega_m) * \tilde{\mu}_i$$

$$(E5) \qquad \sum_{i \in \mathcal{A}} N_i = 2^c$$

$$(E6) \qquad c_{i,j} \rightleftarrows (s_i, q_j)$$

$$(E7) \qquad \Lambda = \prod_{t=1}^{K_H} n_t$$

$$(E8) \qquad K'_B = \lfloor log_2(\Lambda) \rfloor$$

$$(E9) \qquad \gamma = \sum_{r=1}^{K_H} b_{r+K_B-K'_B} 2^{r-1}.$$

$$(E10) \qquad u_{\mathcal{T}} \text{bits} \rightleftarrows \begin{cases} v_{\mathcal{T},1} \text{ variables 2-valuée,} & e_{1,1}, e_{2,1}, \ldots, e_{v_{\mathcal{T},1},1} \\ v_{\mathcal{T},2} \text{ variables 3-valuée,} & e_{1,2}, e_{2,2}, \ldots, e_{v_{\mathcal{T},2},2} \\ \ldots \\ v_{\mathcal{T},\nu} \text{ variables } f_{\nu_i}\text{-valuée,} & e_{1,\nu}, e_{2,\nu}, \ldots, e_{v_{\mathcal{T},\nu},\nu} \end{cases}$$

$$(E11) \qquad \forall i \in [1..\Omega], \ \exists l_i \in \mathbb{N} \ / \ N_i = 2^{l_i}$$

$$(E12) \qquad D_i = log_2(N_i) = c - l_i$$

(E13) $\qquad P(S_t S_{t+1} \ldots S_{t+C-1}) = P(S_t) P(S_{t+1}/S_t) \ldots P(S_{t+C-1}/S_{t+C-2})$

Annexe 2 - Algorithmes

$$
A1 \left|
\begin{array}{l}
\gamma' = \gamma \\[4pt]
Pour\ t = 1\ :\ K_H \\[4pt]
\quad q_t = \gamma'\ modulo\ n_t \\[4pt]
\quad \gamma' = \frac{\gamma' - q_t}{n_t} \\[4pt]
Fin\ pour
\end{array}
\right.
$$

$$
A2 \left|
\begin{array}{l}
z = 0 \\[4pt]
\%\ \text{Tant qu'il reste des variables } f_j\text{-valuées à obtenir} \\[4pt]
Tant\ que\ sum(d_j) > 0 \\[4pt]
\quad \left|
\begin{array}{l}
\%\ \text{Calcul du nombre de fois que la transformation } \mathcal{T}_z \text{ est utilisée} \\[4pt]
g_{\mathcal{T}_z} = floor(min(\frac{d_j}{v_{\mathcal{T}_z,j}}))\ \text{où } v_{\mathcal{T}_z,j} \neq 0 \\[4pt]
\%\ \text{Calcul du nombre de variables } f_j\text{-valuée} \\[4pt]
\%\ \text{qui n'ont pas été transformées par la transformation } \mathcal{T}_z \\[4pt]
Pour\ chaque\ j\ entre\ 1\ et\ \nu \\[4pt]
\quad \left|
\begin{array}{l}
d_j = d_j - g_{\mathcal{T}_z} * v_{\mathcal{T}_z,j} \\[4pt]
\%\ \text{Essaie la transformation suivante} \\[4pt]
z = z + 1
\end{array}
\right.
\end{array}
\right.
\end{array}
\right.
$$

$$A3 \begin{vmatrix} e' = e \\ Pour\ j = 1\ :\ \nu \\ \qquad Pour\ r = 1\ :\ v_{T,j} \\ \qquad\qquad e_{r,j} = e'\ modulo\ f_j \\ \qquad\qquad e' = \frac{e' - e_{r,j}}{f_j} \\ \qquad Fin\ pour \\ Fin\ pour \end{vmatrix}$$

$$A4 \begin{vmatrix} Pour\ j = 1\ :\ \nu \\ \qquad tj = 1 \\ Fin\ pour \\ \\ Pour\ t = 1\ :\ K_H \\ \qquad q_t = 0 \\ \qquad Pour\ j = \nu\ :\ 1\ par\ -1 \\ \qquad\qquad Pour\ r = 1\ :\ \alpha_{t,j} \\ \qquad\qquad\qquad q_t = q_t * f_j + F_j(t_j) \\ \qquad\qquad\qquad tj = tj + 1 \\ \qquad\qquad Fin\ pour \\ \qquad Fin\ pour \\ Fin\ pour \end{vmatrix}$$

## Revendications

1. Codeur de compression de données numériques, comprenant:

- une entrée pour un premier flux de données ($S_H$), et un second flux de données ($S_L$),
- un module de codage, établissant une correspondance entre des symboles du premier flux de données et des mots de code, où pour certains symboles, il existe plusieurs mots, dits redondants, correspondant au même symbole, et
- un module de traitement apte à coder chaque symbole du premier flux de données avec un des mots de code associés audit symbole par la correspondance établie par le module de codage, lequel mot de code est sélectionné parmi les mots redondants en fonction d'une partie au moins du second flux de données, lesdits mots de code sélectionnés formant un flux multiplexé,

ledit codeur étant **caractérisé en ce que** le module de traitement comprend :

- une fonction de calcul d'une capacité de multiplexage d'au moins un symbole du premier flux de données ($S_H$) à partir de données du premier flux de données ($S_H$) et de la correspondance établie par le module de codage ;
- une fonction d'extraction d'une partie du second flux de données ($S_L$) déterminée à partir de ladite capacité de multiplexage, et
- une fonction de sélection, parmi les mots redondants, d'au moins un mot de code en fonction de ladite partie extraite du second flux de données ($S_L$),

et **en ce qu'**il comprend également un module de concaténation de la partie dudit second flux différente de ladite partie extraite et dudit flux multiplexé.

2. Codeur selon la revendication 1, **caractérisé en ce que** les mots de code sont de longueur fixe.

3. Décodeur, propre à effectuer les opérations inverses de celle du codeur de l'une des revendications précédentes.

4. Procédé de compression de données numériques, **caractérisé par** les étapes suivantes :

a. établir (160) une correspondance entre des symboles d'un premier flux de données et des mots de code, où, à certains symboles sont associés plusieurs mots de code, dits redondants, et

b. coder (6-1, 29-1, VII) chaque symbole du premier flux de données avec un des mots de code associés audit symbole par la correspondance établie à l'étape a., ledit mot de code étant sélectionné parmi les mots redondants en fonction d'une partie au moins d'un second flux de données, lesdits mots de code sélectionnés formant un flux multiplexé,

le procédé étant **caractérisé en ce que** l'étape b. comprend les sous-étapes suivantes :

- calculer (3-2, 25, I, 42) une capacité de multiplexage d'au moins un symbole du premier flux de données ($S_H$) à partir de données du premier flux de données ($S_H$) et de la correspondance établie à l'étape a.,
- extraire (4-2, 26-2, II, 44) une partie du second flux de données ($S_L$), dite partie extraite, déterminée à partir de ladite capacité de multiplexage, et
- sélectionner (6-1, 29-1, VII, 46), parmi les mots redondants, au moins un mot de code en fonction de ladite partie extraite du second flux de données ($S_L$),

et **en ce qu'**il comprend en outre une étape de concaténation (7-2, 30-2, IX) de la partie dudit second flux différente de ladite partie extraite et dudit flux multiplexé.

5. Procédé de compression de données numériques, selon la revendication 4, dans lequel la correspondance est établie à l'étape a. à l'aide d'une table de codage ladite table associant à chaque symbole au moins un mot de code.

6. Procédé de compression de données numériques, selon la revendication 4, dans lequel la correspondance est établie à l'étape a. à l'aide d'un arbre binaire de codage contenant, pour chaque symbole du premier flux de données, une première partie de mot de code, de longueur variable et inférieure à une longueur maximale.

7. Procédé de compression de données numériques selon la revendication 4, dans lequel la correspondance est établie à l'étape a. à l'aide un codeur arithmétique propre à calculer, pour une séquence de symboles du premier flux de données, une première partie de mot de code, de longueur variable et inférieure à une longueur maximale.

8. Procédé de compression de données numériques selon l'une des revendications 4 à 7, caractérisé en ce le nombre de mots de code associés à chacun des symboles est égal à une puissance de 2.

9. Procédé de compression de données numériques, selon l'une des revendications 4 à 8, caractérisé qu'il comprend, préalablement à l'étape d'extraction (4-2, 26-2, II, 44), une étape de codage (1-2, 21-2, 40) du second flux ($S_L$) en un flux binaire (b) et en ce que l'étape d'extraction (4-2, 26-2, II, 44) est appliquée sur ce flux binaire (b).

10. Procédé de compression de données numériques, selon l'une des revendications 4 à 9, **caractérisé en ce qu'**il comprend, préalablement à l'étape de sélection (6-1, 29-1, VII, 46), une étape de transformation (5-2, 28-2, V) de la partie extraite en un flux de variables multi-valuées.

EP 1 525 663 B1

**11.** Procédé de compression de données numériques, selon la revendication 10, caractérisé que des mots de code sont sélectionnés parmi les mots redondants correspondant audit symbole en fonction dudit flux de variables multi-valuées pour former ledit flux multiplexé.

**12.** Procédé de décompression de données numériques, **caractérisé par** les étapes réciproques de celles du procédé selon l'une des revendications 4 à 11.

**13.** Procédé de compression de données numériques, selon l'une des revendications 4 à 11, **caractérisé en ce que** les mots de code sont de longueur fixe.

**Claims**

**1.** Digital data compression encoder, comprising:

- an input for a first data stream ($S_H$), and a second data stream ($S_L$),
- an encoding module, associating with symbols of the first data stream code words, wherein, with certain symbols of the first data stream several code words are associated, called redundant code words, and
- a processing module for encoding each symbol of the first data stream with one of the code words associated with said symbol by the encoding module, said code word being selected among the redundant code words, on the basis of at least one part of the second data stream, the selected code words forming a multiplexed stream,

The encoder being **characterized in that** the processing module comprises:

- a function to calculate a multiplexing capacity of at least one symbol of the first data stream ($S_H$), based on data of the first data stream ($S_H$) and based on the association established by the encoding module,
- a function to extract a part from the second data stream ($S_L$), determined on the basis of said multiplexing capacity, and
- a function to select, among the redundant code words, at least one code word based on said extracted part of said second data stream ($S_L$),

and **characterized in that** it further comprises a concatenation module for concatenating the part of said second stream different from said extracted part and said multiplexed stream.

**2.** Encoder according to claim 1, **characterized in that** the code words are of fixed length.

**3.** Decoder designed to perform the inverse operations relative to those of the encoder according to any of the foregoing claims.

**4.** Digital data compression method, **characterized by** the following steps:

a. associating (160) with symbols of a first data stream code words, wherein, with certain symbols of the first data stream several code words are associated, termed redundant code words, and
b. encoding (6-1, 29-1, VII) each symbol of the first data stream with one of the code words associated with said symbol at step a., said code word being selected among the redundant code words, on the basis of at least one part of a second data stream, , the selected code words forming a multiplexed stream,

the method being **characterized in that** the step b. comprises the following sub-steps:

- calculating (3-2, 25, I, 42) a multiplexing capacity of at least one symbol of the first data stream ($S_H$), based on data of the first data stream ($S_H$) and based on the association established at step a.,
- extracting (4-2, 26-2, II, 44) a part from the second data stream ($S_L$), called extracted part, determined on the basis of said multiplexing capacity, and
- selecting (6-1, 29-1, VII, 46), among the redundant code words, at least one code word based on said extracted part of said second data stream ($S_L$),

and **characterized in that** it further comprises a concatenation step for concatenating the part of said second stream different from said extracted part and said multiplexed stream.

14

5. Digital data compression method, according to claim 4, wherein the association is established at step a. by an encoding table, said table associating with each symbol at least one code word.

6. Digital data compression method, according to claim 4, wherein the association is established at step a. by a binary encoding tree containing, for each symbol in the first data stream, a first code word part, of variable length and shorter than a maximum length.

7. Digital data compression method, according to claim 4, wherein the association is established at step a. by an arithmetic encoder designed to calculate, for a symbol sequence in the first data stream, a first code word part of variable length and shorter than a maximum length.

8. Digital data compression method, according to any of claims 4 to 7, wherein the number of code words associated with each symbol at step a. equal to a power of 2.

9. Digital data compression method, according to any of claims 4 to 8, wherein the method comprises prior to the extraction step (4-2, 26-2, II, 44), a step of encoding (1-2, 21-2, 40) said second data stream (SL) in a binary stream (b) and wherein the extracting step (4-2, 26-2, II, 44) applies on said binary stream (b).

10. Digital data compression method according to any of claims 4 to 9, wherein the method comprises, prior to the selection step (6-1, 29-1, VII, 46), a transformation step (5-2, 28-2, V) of the extracted part into a multi-valued variable stream.

11. Digital data compression method, according to claim 10, wherein code words are selected among the redundant code words associated with said symbol based on the multi-valued variable stream in order to form said multiplexed stream.

12. Digital data decompression method, **characterized by** steps reciprocal to those of the method according to either of claims 4 to 11.

13. Digital data compression method, according to any of claims 4 to 11, wherein the code words are of fixed length.

**Patentansprüche**

1. Komprimierungscodierer für digitale Daten, umfassend:

- einen Eingang für einen ersten Datenfluss ($S_H$) und einen zweiten Datenfluss ($S_L$),
- ein Codierungsmodul, das eine Entsprechung zwischen Symbolen des ersten Datenflusses und Codeworten erstellt, wobei es für bestimmte Symbole mehrere Worte, redundant genannt, gibt, die demselben Symbol entsprechen, und
- ein Verarbeitungsmodul, das in der Lage ist, jedes Symbol des ersten Datenflusses mit einem der Codeworte zu codieren, die dem Symbol durch die Entsprechung zugeordnet werden, die durch das Codierungsmodul erstellt wird, wobei das Codewort unter den redundanten Worten in Abhängigkeit von mindestens einem Teil des zweiten Datenflusses ausgewählt wird, wobei die ausgewählten Codeworte einen gemultiplexten Fluss bilden,

wobei der Codierer **dadurch gekennzeichnet ist, dass** das Verarbeitungsmodul umfasst:

- eine Funktion zur Berechnung einer Multiplexkapazität von mindestens einem Symbol des ersten Datenflusses ($S_H$) auf der Grundlage von Daten des ersten Datenflusses ($S_H$) und von der Entsprechung, die durch das Codierungsmodul erstellt wird;
- eine Funktion zur Extraktion eines Teiles aus dem zweiten Datenfluss ($S_L$), der auf der Grundlage der Multiplexkapazität ermittelt wird, und
- eine Funktion zur Auswahl, unter den redundanten Worten, von mindestens einem Codewort in Abhängigkeit von dem aus dem zweiten Datenfluss ($S_L$) extrahierten Teil,

und dass er auch ein Verkettungsmodul des Teiles des zweiten Flusses umfasst, der sich von dem extrahierten Teil und dem gemultiplexten Fluss unterscheidet.

**2.** Codierer nach Anspruch 1, **dadurch gekennzeichnet, dass** die Codeworte eine feste Länge aufweisen.

**3.** Decodierer, der geeignet ist, die Arbeitsgänge umgekehrt zu denen des Codierers nach einem der vorhergehenden Ansprüche auszuführen.

**4.** Komprimierungsverfahren von digitalen Daten, **gekennzeichnet durch** die nachfolgenden Schritte:

a. Erstellen (160) einer Entsprechung zwischen Symbolen eines ersten Datenflusses und Codeworten, wobei bestimmten Symbolen mehrere Codeworte, redundant genannt, zugeordnet werden, und
b. Codieren (6-1, 29-1, VII) von jedem Symbol des ersten Datenflusses mit einem der Codeworte, die dem Symbol **durch** die Entsprechung zugeordnet werden, die in Schritt a. erstellt wird, wobei das Codewort unter den redundanten Worten in Abhängigkeit von mindestens einem Teil aus einem zweiten Datenfluss ausgewählt wird, wobei die ausgewählten Codeworte einen gemultiplexten Fluss bilden,

wobei das Verfahren **dadurch** gekennzeichnet ist, dass der Schritt b. die nachfolgenden Teilschritte umfasst:

- Berechnen (3-2, 25, I, 42) einer Multiplexkapazität von mindestens einem Symbol des ersten Datenflusses ($S_H$), auf der Grundlage von Daten des ersten Datenflusses ($S_H$) und von der in Schritt a. erstellten Entsprechung,
- Extrahieren (4-2, 26-2, II, 44) eines Teiles aus dem zweiten Datenfluss ($S_L$), extrahierter Teil genannt, der auf der Grundlage der Multiplexkapazität bestimmt wird, und
- Auswählen (6-1, 29-1, VII, 46), unter den redundanten Worten, von mindestens einem Codewort in Abhängigkeit von dem aus dem zweiten Datenfluss ($S_L$) extrahierten Teil,

und dass es außerdem einen Verkettungsschritt (7-2, 30-2, IX) des Teiles aus dem zweiten Datenfluss enthält, der sich von dem extrahierten Teil und dem gemultiplexten Fluss unterscheidet.

**5.** Komprimierungsverfahren von digitalen Daten nach Anspruch 4, bei dem die Entsprechung in Schritt a. mit Hilfe einer Codierungstabelle erstellt wird, wobei die Tabelle jedem Symbol mindestens ein Codewort zuordnet.

**6.** Komprimierungsverfahren von digitalen Daten nach Anspruch 4, bei dem die Entsprechung in Schritt a. mit Hilfe eines binären Codierungsbaumes erstellt wird, der, für jedes Symbol des ersten Datenflusses, einen ersten Teil eines Codewortes mit einer Länge enthält, die variabel und kürzer als eine maximale Länge ist.

**7.** Komprimierungsverfahren von digitalen Daten nach Anspruch 4, bei dem die Entsprechung in Schritt a. mit Hilfe eines arithmetischen Codierers erstellt wird, der geeignet ist, für eine Sequenz von Symbolen des ersten Datenflusses einen ersten Teil des Codewortes einer Länge zu berechnen, die variabel und kürzer als eine maximale Länge ist.

**8.** Komprimierungsverfahren von digitalen Daten nach einem der Ansprüche 4 bis 7, **dadurch gekennzeichnet, dass** die Anzahl von Codeworten, die jedem der Symbole zugeordnet wird, gleich einer Potenz von 2 ist.

**9.** Komprimierungsverfahren von digitalen Daten nach einem der Ansprüche 4 bis 8, **dadurch gekennzeichnet, dass** es vor dem Extraktionsschritt (4-2, 26-2, II, 44) einen Codierungsschritt (1-2, 21-2, 40) des zweiten Flusses ($S_L$) zu einem binären Fluss (b) umfasst und dass der Extraktionsschritt (4-2, 26-2, II, 44) auf diesen binären Fluss (b) angewendet wird.

**10.** Komprimierungsverfahren von digitalen Daten nach einem der Ansprüche 4 bis 9, **dadurch gekennzeichnet, dass** es vor dem Auswahlschritt (6-1, 29-1, VII, 46) einen Umwandlungsschritt (5-2, 28-2, V) des extrahierten Teiles in einen Fluss von mehrwertigen Variablen umfasst.

**11.** Komprimierungsverfahren von digitalen Daten nach Anspruch 10, **dadurch gekennzeichnet, dass** Codeworte unter den redundanten Worten, die dem Symbol entsprechen, in Abhängigkeit von dem Fluss der mehrwertigen Variablen ausgewählt werden, um den gemultiplexten Fluss zu bilden.

**12.** Dekomprimierungsverfahren von digitalen Daten, **gekennzeichnet durch** die Schritte, die reziprok zu denjenigen des Verfahrens nach einem der Ansprüche 4 bis 11 sind.

**13.** Komprimierungsverfahren von digitalen Daten nach einem der Ansprüche 4 bis 11, **dadurch gekennzeichnet,**

**dass** die Codeworte eine feste Länge aufweisen.

**100** $(A, \mu)$

**120-1** $c$

$\forall i \in [1 ... \Omega]$
$(a_i, \mu_i)$

**130-1** $\mu_i \leqslant \dfrac{1}{2^c}$

oui

non

**130-3** $a_i \in A_M$

**120-2** Génération des mots de code $c_p, p \in [0 .. 2^c - 1]$

**130-2** $a_i \in A_m$ $N_i = 1$

**140** $\tilde{\mu}_i = \dfrac{2^c}{2^c - \Omega_M} \mu_i$

$N_i / A_m$

**150-1** $N_i \approx (2^c - \Omega_m) \tilde{\mu}_i$

**150-11** Contrainte sur $N_i : N_i = \Pi_{j=1}^{\Upsilon} f_j^{\alpha_{i,j}}$

$N_i / A_M$

**150-2** $\forall i \in A, N_i$

**160** $\forall i$, affectation de $N_i$ mots de code

**180** Classes d'équivalence des mots de codes $\{C_1 ... C_\Omega\}$

# FIG.1

FIG.2

| classe $C_i$ | Mot de code $c_{i,q}$ | symbole $a_i$ | $N_i = card(C_i)$ | probabilité $\mu_i$ | état q |
|---|---|---|---|---|---|
| $C_1$ | 0000<br>0001<br>0010<br>0011<br>0100<br>0101 | a | 6 | 0.43 | 0<br>1<br>2<br>3<br>4<br>5 |
| $C_2$ | 0110<br>0111<br>1000<br>1001<br>1010 | b | 5 | 0.30 | 0<br>1<br>2<br>3<br>4 |
| $C_3$ | 1011<br>1100<br>1101<br>1110 | c | 4 | 0.25 | 0<br>1<br>2<br>3 |
| $C_4$ | 1111 | d | 1 | 0.02 | 0 |

FIG.2A

$S_H$
$S_1, ..., S_t, ... S_{K_H}$ — 2-1

Lecture table des codes multiplexés — 2-2

$\forall t \in [1..K_H], n_t$ — 2-3

$\Lambda = \prod_{t=1}^{K_H} n_t$ — 3-1

$K_B' = \log_2(\lfloor \Lambda \rfloor)$ — 3-2

Réduction de la part de $S_H$ qui sera multiplexante $K_H = K_H \dfrac{K_B}{K_B'}$ — 4-11

$S_L$ — 1-1

Encodage réversible — 1-2

$b$
$b_1, ..., b_t, ... b_{K_B}$ — 1-3

découpage du flux $b$ en deux parties — 4-2

partie multiplexée $b_{K_B - K_B' + 1}, ..., b_t, ... b_{K_B}$ — 4-3

$K_B < K_B'$ — 4-1 — oui / non

Calcul de la valeur de description du flux $S_L$
$\sum_{r=1}^{K_H} b_{r + K_B - K_B'} 2^{r-1}$ — 4-4

décomposition euclidienne itérative suivant $n_1, ... n_{K_H}$ de $\gamma$ — 5-1

$\gamma$ — 4-5

Partie concaténée $b_1, ..., b_t, ... b_{K_B - K_B'}$ — 7-1

flux d'états q
$q = q_1, ..., q_{K_H}$ — 5-2

Concaténation du flux multiplexé m et de la partie non multiplexée de $b$ — 7-2

détermination des mots de code par lecture de table: $\forall t, m_t = f(s_t, q_t)$ — 6-1

flux multiplexé:
$m = m_1, ..., m_{K_H}$ — 6-2

flux transmis — 7-3

## FIG.3

$S_H$
$S_1,...,S_t,...SK_H$ — 22-1

$S_L$ — 21-1

Lecture table des codes multiplexés — 22-2

Réduction de la part de $S_H$ qui sera multiplexante
$K_H = K_H \dfrac{K_B}{K'_B}$ — 26-11

Encodage réversible — 21-2

$\forall t \in [1..K_H], n_t$ — 22-3

$b$
$b_1,...,b_t,...b_{K_B}$ — 21-3

Calcul de nombre de variables $f_j$-valuées qui peuvent être multiplexées avec $s_H$ — 23-1

découpage du flux $b$ en deux parties — 26-2

$d_1,...,d_j,...d_v$ — 23-2

oui — 26-1

$K_B < K'_B$?

non

partie multiplexée
$b_{K_B \cdot K'_B +1},...,b_t,...b_{K_B}$ — 26-3

Choix des transformations permettant d'obtenir les $d_1,...d_v$ variables de chaque type (2-valuée, ...$f_v$-valuée) — 24-1

Transformations du flux binaire selon les transformations choisies — 27-1

Nb transformations
$g_0,...,g_z,...g_{z_{max}}$ — 24-2

Calcul du nombre de bits multiplexés $K'_B$ — 25

Partie concaténée
$b_1,...,b_t,...b_{K_B \cdot K'_B}$ — 30-1

flux d'états $q$
$q = q_1,...,q_{K_H}$

Calcul du flux d'états — 28-1

flux $F_1,...,F_v$ — 27-2

Concaténation du flux multiplexé $m$ et de la partie non multiplexée de $b$ — 30-2

28-2

détermination des mots de code par lecture de table: $\forall t, m_t = f(s_t, q_t)$ — 29-1

flux multiplexé :
$m = m_1,...,m_{K_H}$ — 29-2

flux transmis — 30-3

FIG.4

## FIG.5

| $T_z$ identificateur | $U_{T_z}$ | $V_{T_z,1}$ | $V_{T_z,2}$ | $V_{T_z,3}$ | $O_{T_z}$ |
|---|---|---|---|---|---|
| $T_0$ | 1 | 1 | 0 | 0 | 0.0000 |
| $T_1$ | 15 | 0 | 8 | 1 | 0.0001 |
| $T_2$ | 21 | 0 | 3 | 7 | 0.0004 |
| $T_3$ | 19 | 0 | 12 | 0 | 0.0010 |
| $T_4$ | 25 | 0 | 7 | 6 | 0.0011 |
| $T_5$ | 24 | 0 | 2 | 9 | 0.0028 |
| $T_6$ | 14 | 0 | 3 | 4 | 0.0030 |
| $T_7$ | 18 | 0 | 7 | 3 | 0.0034 |
| $T_8$ | 27 | 0 | 1 | 11 | 0.0047 |
| $T_9$ | 17 | 0 | 2 | 6 | 0.0060 |
| $T_{10}$ | 30 | 0 | 0 | 13 | 0.0062 |
| $T_{11}$ | 20 | 0 | 1 | 8 | 0.0080 |
| $T_{12}$ | 11 | 0 | 7 | 0 | 0.0086 |
| $T_{13}$ | 23 | 0 | 0 | 10 | 0.0095 |
| $T_{14}$ | 6 | 0 | 1 | 2 | 0.0381 |
| $T_{15}$ | 3 | 0 | 2 | 0 | 0.0566 |
| $T_{16}$ | 2 | 0 | 0 | 1 | 0.1610 |
| $T_{zmax} = T_{17}$ | 1 | 0 | 1 | 0 | 0.5850 |

## FIG.6

$$S_H = S_1, \ldots, S_t, \ldots S_{K_H}$$

**I**

Calcul de la capacité de multiplexage

$n_1, \ldots, n_t, \ldots n_{K_H}$

$K'_B$

**II**

$b$

$b_1, \ldots, b_t, \ldots b_{K_B}$

Séparation du flux b en deux parties

Partie concaténée

$b'' = b''_1 \ldots b''_{K_B - K'_B}$

$b' = b'_1 \ldots b'_{K'_B}$

**V**

Transformation de b' en une suite d'états

flux d'états q

$q = q_1, \ldots, q_{K_H}$

**VII**

Choix des mots de code multiplexés

flux multiplexé

$m = m_1, \ldots, m_{K_H}$

**Π**

**VIII**

Concaténation du flux multiplexé m et de la partie non multiplexée de b

**IX**

flux transmis

FIG.8

```
        ┌────────────────────┐
        │   VARIANTE  DU      │
        │ PROCÉDÉ D'ENCODAGE  │
        └────────────────────┘
                  │
                  ▼
        ┌────────────────────┐
        │ ENCODAGE REVERSIBLE │──── 40
        │ DU FLUX Sₗ EN FLUX b│
        └────────────────────┘
                  │
                  ▼
        ┌────────────────────┐
        │  LECTURE DE Sₜ  ET  │
   ┌───▶│ LECTURE DE TABLE    │──── 42
   │    │    ─────▶ Dₜ        │
   │    └────────────────────┘
   │              │
   │              ▼
   │    ┌────────────────────┐
   │    │  LECTURE DES Dₜ     │
   │    │ PROCHAINS BITS DU   │──── 44
   │    │   FLUX b ─────▶ Uₜ  │
   │    └────────────────────┘
   │              │
   │              ▼
   │    ┌────────────────────┐
   │    │  CHOIX DE C_{Sₜ,Uₜ} │
   │    │ DANS LA TABLE ET    │──── 46
   │    │ EMISSION SUR CANAL  │
   │    └────────────────────┘
   │              │
   │              ▼
   │    ┌────────────────────┐
   └────│   Sₜ ◀──── Sₜ₊₁     │──── 48
        └────────────────────┘
                  │
                  ▼
              (  FIN  )
```

$$\text{CHOIX DE } C_{S_t, \overline{U_t}}$$

$$\text{LECTURE DES } D_t \text{ PROCHAINS BITS DU FLUX } b \longrightarrow \overline{U_t}$$

$$S_t \longleftarrow S_{t+1}$$

# FIG.9

| class $C_i$ | $c_i, \overline{U_i}$ | $a_i$ | $D_i$ | $N_i = 2^{l_i}$ | $\mu_i$ | $\overline{U_i}$ |
|---|---|---|---|---|---|---|
| $C_1$ | 000<br>001 | $a_1$ | 1 | 2 | 0.30 | 0<br>1 |
| $C_2$ | 010<br>011<br>100<br>101 | $a_2$ | 2 | 4 | 0.43 | 00<br>01<br>10<br>11 |
| $C_3$ | 110 | $a_3$ | 0 | 1 | 0.25 | $\emptyset$ |
| $C_4$ | 111 | $a_4$ | 0 | 1 | 0.02 | $\emptyset$ |

11-B   12-B   13-B   18-B   14-B   15-B   17-B

B

## FIG.2B

—— $s_H$

---- b

## FIG.7

| $S_t$ | $a_2$ | $a_1$ | $a_1$ | $a_3$ | $a_1$ | $a_2$ | $a_1$ | $a_4$ | $a_2$ | $a_1$ |
|---|---|---|---|---|---|---|---|---|---|---|
| préfixe | 10. | 0.. | 0.. | 110 | 0.. | 10. | 0.. | 111 | 10. | 0.. |
| suffixe $\overline{u_t}$ | ..0 | .10 | .10 | ... | .10 | .1 | .01 | ... | ..0 | .10 |
| $m_t$ | 100 | 010 | 010 | 110 | 010 | 101 | 001 | 111 | 100 | 010 |

## FIG.10

$S_H$

50

$$S_1 \quad ... \quad S_C \quad S_{C+1} \quad ... \quad S_{2C} \qquad\qquad S_{\frac{K}{C}-C+1} \ ... \ S_{\frac{K}{C}}$$

52

53

55

$(S_1, ... S_C)$

$(S_{C+1}, ... S_{2C})$

$...$

$(S_{K-C+1}, ... S_K)$

S1

$H_1$

$H_2$

$H$

$H_{\frac{K}{C}}$

62

m

64

multiplexage

60

b

FIG.11

$S_H$

70

$$S_1 \quad ... \quad S_C \quad S_{C+1} \ ... \ S_{2C} \qquad\qquad S_{\frac{K}{C}-C+1} ... \ S_{\frac{K}{C}}$$

Arihm$_1$

Arihm$_2$

$...$

Arihm$_{\frac{K}{C}}$

71

72

73

75

81-1

81-2

82-1

82-2

85-1

$H_1$

$H_2$

$H_{\frac{K}{C}}$

85-2

c

90

b

FIG.12

26

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6020923 A
- US 4286256 A
- US 4467317 A
- US 4652856 A

**Littérature non-brevet citée dans la description**

- A method for the construction of minimum redundancy codes. **D.A. HUFFMAN.** Proc. IRE. 1951, vol. 40, 1098-1101
- **J.J. RISSANEN.** Generalized kraft inequality and arithmetic. *IBM J.Res. Develop.,* Mai 1976, vol. 20, 198-203
- **J.J. RISSANEN.** Arithmetic Coding as number representations. *Acta Polytech. Scand. Math.,* Décembre 1979, vol. 31, 44-51